Europäisches Patentamt

European Patent Office

Office européen des brevets

(11) Numéro de publication : **0 153 239 B1**

# (12) FASCICULE DE BREVET EUROPÉEN

(45) Date de publication du fascicule du brevet :
**17.08.88**

(21) Numéro de dépôt : **85400240.9**

(22) Date de dépôt : **13.02.85**

(51) Int. Cl.⁴ : **H 04 B 5/00,** H 04 H 1/06,
H 03 H 7/42

(54) **Système rayonnant pour la radiodiffusion dans les tunnels routiers et équipement d'alimentation de ce système.**

(30) Priorité : **21.02.84 FR 8402575**

(43) Date de publication de la demande :
**28.08.85 Bulletin 85/35**

(45) Mention de la délivrance du brevet :
**17.08.88 Bulletin 88/33**

(84) Etats contractants désignés :
**AT CH DE GB IT LI SE**

(56) Documents cités :
**FR-A- 833 614
FR-A- 1 210 831
FR-A- 2 189 889
US-A- 3 766 476
IEEE SPECTRUM, vol. 17, no. 7, juillet 1980, pages 26-29, New York, US; P. DELOGNE: "Radio goes underground"**

(73) Titulaire : **Etablissement Public de Diffusion dit "Télédiffusion de France"
21-27 rue Barbès
F-92120 Montrouge (FR)**

(72) Inventeur : **Piole, Philippe
18, rue Chemin Mari Widor
F-35000 Rennes (FR)**
Inventeur : **Collec, Jean
Léperon 18 Place Juin
F-35000 Rennes (FR)**

(74) Mandataire : **Mongrédien, André et al
c/o BREVATOME 25, rue de Ponthieu
F-75008 Paris (FR)**

**0 153 239**

## Description

La présente invention a pour objet un système rayonnant pour la radiodiffusion dans les tunnels routiers et un équipement d'alimentation de ce système.

On sait que la propagation des ondes radioélectriques dans la gamme kilométrique (ondes dites « longues ») ou hectométrique (ondes dites « moyennes ») est difficile dans les tunnels routiers, du fait d'une atténuation importante que subit le mode naturel de propagation. Il en résulte un affaiblissement, voire un évanouissement, des ondes radiodiffusées et, par conséquent, une gêne pour les conducteurs de véhicules automobiles à l'écoute de leurs radiorécepteurs.

Les études effectuées sur ce sujet ont montré que la propagation naturelle en ondes longues et moyennes n'est exploitable que dans le cas de tunnels très courts et pour des fréquences supérieures à une fréquence de coupure. Pour les programmes en modulation de fréquence, dont la fréquence porteuse est élevée et se situe aux alentours de 90 MHz, les conditions sont moins défavorables et l'on peut rediffuser ces ondes dans un tunnel à l'aide d'un câble coaxial à fuites (câble coaxial percé d'ouverture) qui longe la paroi du tunnel. Mais dans la gamme allant de 150 kHz à 1 700 kHz (ondes longues et moyennes correspondant à des programmes émis en modulation d'amplitude), la réalisation d'un système rayonnant convenable pose de sérieux problèmes.

Dans l'art antérieur, on emploie à cette fin un câble conducteur unique suspendu à la paroi du tunnel. Le câble et la paroi forment une ligne de propagation fonctionnant en mode quasi-TEM (« Transverse-Electrique-Magnétique »). Pour un tel mode, il n'y a pas de fréquence de coupure.

Cette technique est décrite par exemple dans l'article de la revue IEEE SPECTRUM, vol 17, n° 7 juillet 1980, pages 26-29 dans un article publié par P.P. DELOGNE et intitulé « Radio Goes Underground ».

Une telle solution présente cependant de nombreux inconvénients. Tout d'abord, l'atténuation présentée par la ligne dépend de la fréquence (elle augmente avec celle-ci). Les conditions de propagation ne sont donc pas uniformes. Par ailleurs, cette atténuation dépend de la position du câble dans le tunnel : une position excentrée provoque une distortion des lignes de champ et diminue le couplage à l'antenne des récepteurs. Mais une position centrée s'accommode mal des contraintes liées à la circulation des véhicules dans le tunnel. Enfin, la présence de masses métalliques dans le tunnel, (ventilateur, panneaux, etc...) d'hétérogénéités dans la paroi de celui-ci provoquent des perturbations dans les conditions de propagation de l'onde radioélectrique de sorte que l'impédance caractéristique et l'atténuation linéique présentées par la ligne changent le long de celle-ci. Il en résulte des désadaptations d'impédances, des régimes d'ondes stationnaires, des hétérogénéités de champ.

L'utilisation d'une seule ligne entraîne un autre inconvénient qui tient à ce qu'un effet de masque peut apparaître lorsqu'un véhicule de fort gabarit s'interpose entre l'antenne de réception d'un véhicule et le câble rayonnant. Pour maintenir un confort d'écoute satisfaisant, il est alors nécessaire d'alimenter le système rayonnant avec une puissance considérable, ce qui n'est pas sans poser des problèmes du fait des normes fixant les taux d'intermodulation entre canaux. La fiabilité des matériels s'en trouve amoindrie et leur coût augmenté.

Un second problème apparaît, dans l'art antérieur, en ce qui concerne la sécurité de fonctionnement du système. Comme le câble rayonnant utilisé est unique, le système devient totalement inopérant en cas d'avarie provoquée par exemple par un accident automobile. Aucun message de service (instruction, consignes, etc....) ne peut plus alors être émis dans le tunnel à un moment où justement le besoin s'en fait sentir.

Dans l'article cité plus haut, il est également fait mention de l'utilisation possible d'une boucle constituée par deux conducteurs placés de part et d'autre du centre du tunnel. Cette boucle est équivalente à une ligne de transmission à deux fils pouvant propager des modes quasi-TEM. Cette ligne est le siège de deux types de modes, l'un dit équilibré l'autre dit déséquilibré. Mais cette technique présente encore des inconvénients car, du fait de dissymétries inévitables entre les deux lignes, l'énergie se convertit peu à peu dans le mode déséquilibré, qui, malheureusement, possède des pertes les plus élevées, qui augmentent encore avec la fréquence. Pratiquement, on ne peut dépasser une fréquence de quelques centaines de kilohertz et des distances de quelques kilomètres.

Une autre solution préconisée par l'article cité plus haut consiste à utiliser une ligne à fuites généralement du type câble coaxial, qui évite l'atténuation élevée des lignes monofilaires ou à boucle. Une telle ligne est bien adaptée aux fréquences élevées des bandes VHF ou UHF. Mais, inversement, elle est mal adaptée à la propagation des ondes à fréquence basse correspondant aux ondes dites longues et moyennes.

L'invention combine les dispositions des lignes bifilaires et du câble coaxial à fuites.

A cette fin, elle préconise l'emploi de deux câbles rayonnants alimentés en parallèle et disposés de part et d'autre du tunnel, l'un des câbles au moins étant constitué par la gaine extérieure d'un câble coaxial à fuites. Ces deux câbles sont suspendus à des chemins métalliques qui, dans la quasi totalité des tunnels, servent de support à divers câbles d'alimentation (pour les ventilateurs, les feux de signalisation, éclairage, etc...).

Le câble coaxial est alimenté à une extrémité par un conducteur coaxial véhiculant une onde en modulation de fréquence, ce conducteur étant en partie bobiné sur un noyau magnétique et formant

2

**0 153 239**

inductance de blocage pour les ondes longues et moyennes. L'autre extrémité du câble coaxial est connecté à une résistance adaptée. Le système de l'invention comprend encore un répartiteur de puissance à une entrée recevant un signal correspondant à des programmes en ondes longues et moyennes et deux sorties identiques délivrant des signaux de même amplitude et même phase, ces deux sorties étant reliées à l'une des extrémités des câbles suspendus, l'autre extrémité des câbles étant connectée à une charge adaptée. Ces moyens sont bien de nature à résoudre les problèmes rencontrés dans l'art antérieur. L'utilisation de deux câbles permet la rediffusion des ondes longues et moyennes en modulation d'amplitude ; l'utilisation conjointe du câble coaxial à fuites (dont la gaine sert de câble pour les ondes Km et Hm) permet la rediffusion des programmes en modulation de fréquence. Ainsi la totalité des programmes radiophoniques habituels peut-elle être retransmise par le système de l'invention.

Par ailleurs la disposition du câble sous un chemin métallique permet de constituer une ligne à fuites fonctionnant en régime d'ondes progressives. La présence de deux câbles en parallèle (et non en boucle) permet d'éviter la coupure totale en cas de détérioration accidentelle de l'un des câbles, la rupture simultanée des deux câbles étant très peu probable. La disposition du câble de part et d'autre du tunnel permet d'obtenir une excellente homogénéité du champ radioélectrique et évite les effets de masquage, un véhicule étant toujours en vue directe d'un des câbles.

L'invention a également pour objet un équipement d'alimentation du système rayonnant qui vient d'être défini. Cet équipement remplit une double fonction : rediffuser les programmes radiophoniques à l'intérieur du tunnel, permettre la substitution à ces programmes de messages de service destinés aux automobilistes.

Cet équipement comprend essentiellement une première station fonctionnant en modulation d'amplitude, une seconde station fonctionnant en modulation de fréquence, un modulateur traitant les messages de service.

De toute façon, les caractéristiques et avantages de l'invention apparaîtront mieux après la description qui va suivre, d'exemples de réalisation donnés à titre explicatif et nullement limitatif. Cette description se réfère à des dessins annexés sur lesquels :

— la figure 1 représente en coupe un tunnel routier,
— la figure 2 montre la disposition d'un câble rayonnant sous un chemin métallique,
— la figure 3 montre un schéma électrique du système rayonnant,
— la figure 4 montre un mode de réalisation d'un circuit répartisseur de puissance,
— la figure 5 montre un isolateur servant à l'alimentation du câble coaxial,
— la figure 6 montre un schéma synoptique d'un équipement d'alimentation du sytème rayonnant,
— la figure 7 représente la structure de la station fonctionnant en modulation d'amplitude,
— la figure 8 représente la structure de la station fonctionnant en modulation de fréquence,
— la figure 9 représente un exemple de réalisation d'un circuit de modulation,
— la figure 10 représente un mode particulier de réalisation d'un équipement de démodulation et de commande de démodulation.

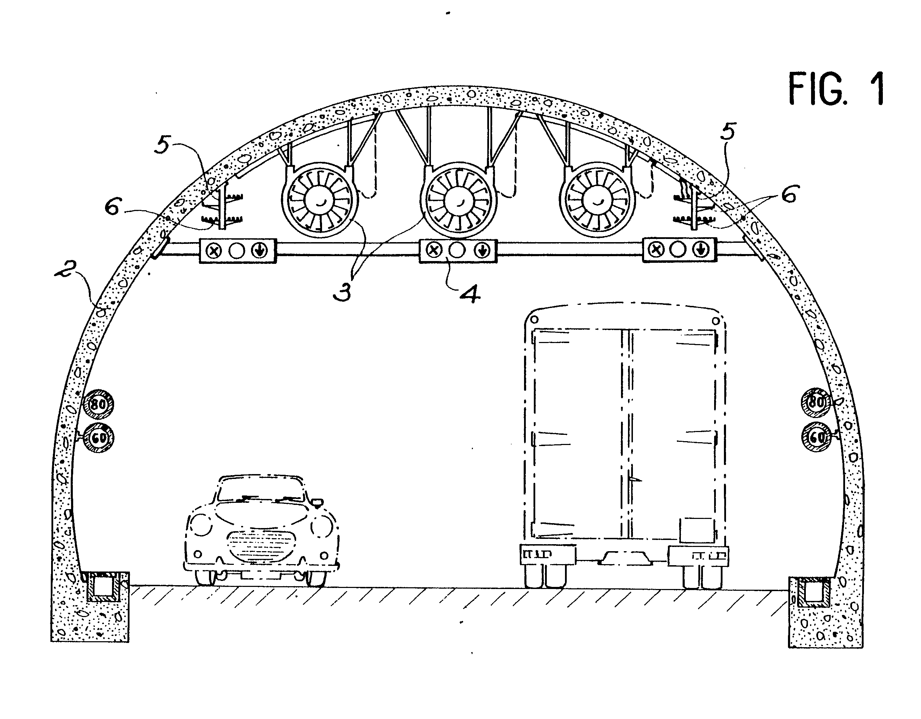

Le tunnel représenté sur la figure 1 comprend une paroi 2 à laquelle sont suspendus divers organes de ventilation 3, de signalisation 4, etc.... De chaque côté du tunnel, des montants 5 supportent des chemins métalliques 6 qui servent de support à divers câbles d'alimentation électrique. Ces chemins sont électriquement à la masse, par leurs montants 5.

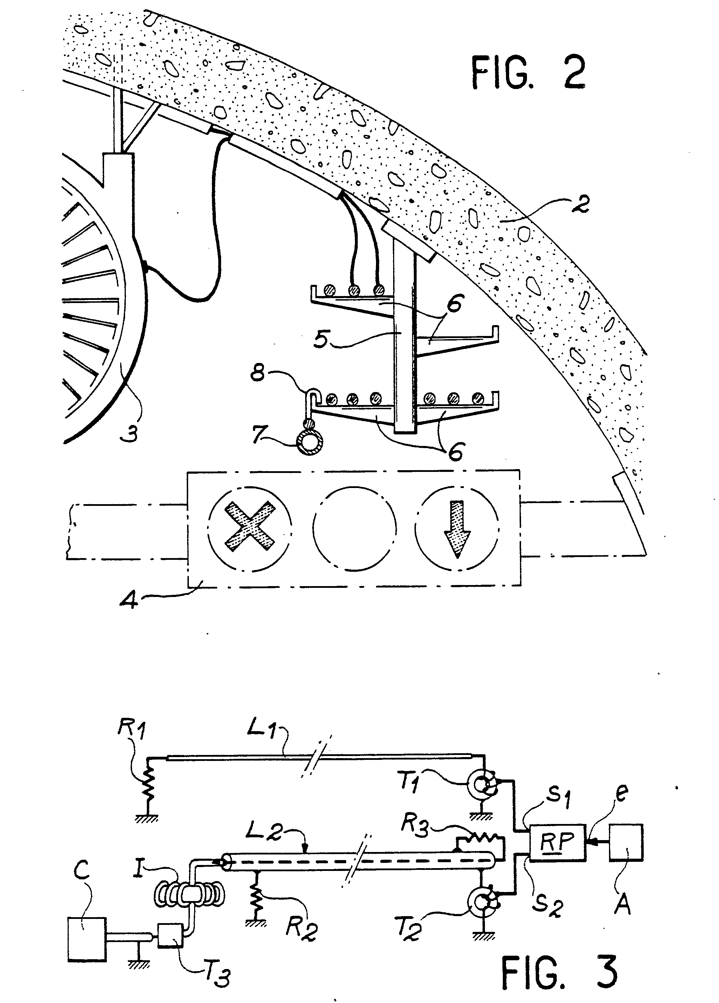

La figure 2 montre un détail de cette structure au niveau des chemins métalliques 6 et permet d'illustrer la première caractéristique de l'invention. Un câble conducteur 7 est suspendu au chemin métallique 6 par une pince isolante 8. La combinaison câble 7-chemin 6 forme une ligne bifilaire à fuite apte à fonctionner en régime d'ondes progressives dans la gamme des ondes longues et moyennes. Comme déjà souligné plus haut, il existe deux telles lignes dans le tunnel de chaque côté de celui-ci.

Des mesures ont été effectuées par le demandeur dans un tunnel à trois voies (une voie centrale et deux voies latérales) équipé de ce système rayonnant à deux lignes. Les résultats sont consignés dans le tableau suivant :

| f | 164 | 220 | 600 | 1700 |
|---|---|---|---|---|
| ROS | 1,23 | 1,12 | 1,08 | 1,12 |
| $\alpha$ | 0,34 | 0,43 | 0,84 | 3 |
| $E_1$ | 94 | 94 | 98 | 98 |
| $E_2$ | 95 | 95 | 98 | 98 |
| $E_3$ | 94 | 94 | 97 | 97 |

Dans ce tableau :
— f est la fréquence exprimée en kHz,
— ROS désigne le rapport d'ondes stationnaires,
— $\alpha$ l'atténuation (en dB par km),
— $E_1$ le champ capté sur l'une des deux voies latérales,

3

— $E_2$ le champ capté sur la voie centrale,

— $E_3$ le champ capté sur l'autre voie latérale, tous ces champs étant exprimés en dB $\mu$V/m.

Ces résultats montrent que le système :

— présente une bonne adaptation, ce qui signifie que son impédance caractéristique est maintenue tout le long de la ligne ; cette propriété permet de disposer une seule charge en bout de ligne et de bénéficier d'un régime d'ondes progressives sur toute la bande des ondes longues et moyennes, sans chute brutale du champ du fait d'un système à caractère stationnaire,

— possède une atténuation acceptable,

— conduit à une remarquable uniformité du champ (fluctuation de 1 dB) ; dans le cas d'un seul câble, il faut souligner qu'on obtiendrait une chute de 20 dB sur la voie opposée au câble, ce qui rend la réception très difficile.

Quant au coefficient de couplage avec une antenne, qui exprime le rapport entre la tension injectée sur le système rayonnant et la tension recueillie par l'antenne, il est compris entre —53,5 dB et —54,5 dB à 164 kHz et entre —50,5 dB et —51,5 dB à 600 kHz, alors que dans un système à un seul câble, ce couplage pouvait descendre à —84 dB.

La figure 3 représente le schéma électrique du système rayonnant de l'invention. Ce système comprend une première ligne $L_1$ formée d'un premier câble conducteur suspendu à un chemin métallique (non représenté) et une seconde ligne $L_2$ formée par la tresse extérieure d'un câble coaxial à fuites, lui aussi suspendu à un chemin métallique (non représenté).

L'alimentation du signal en ondes longues et moyennes des linges $L_1$ et $L_2$ s'effectue par un répartisseur de puissance RP dont l'entrée e est reliée à une station A fonctionnant en modulation d'amplitude et qui sera décrite plus loin. Ce répartisseur délivre sur deux sorties $s_1$ et $s_2$, deux tensions de même amplitude et de même phase. Chacune de ces deux sorties est reliée à une extrémité des linges $L_1$ et $L_2$ à travers des transformateurs d'impédance $T_1$, $T_2$. Les lignes $L_1$ et $L_2$ sont connectées à leur autre extrémité à des résistances de charge $R_1$ et $R_2$.

L'entrée et les sorties du répartisseur se font par exemple sous une impédance de 50 $\Omega$, ce qui permet d'acheminer les alimentations par câbles coaxiaux en minimisant le rayonnement. Les transformateurs $T_1$ et $T_2$ font passer cette impédance à l'impédance caractéristique de chaque ligne. Les résistances $R_1$ et $R_2$ ont alors une valeur aussi proche que possible de cette impédance caractéristique.

L'alimentation de la linge $L_2$ se double d'une partie correspondant aux programmes en modulation de fréquence. Un transformateur d'impédance $T_3$ est relié à une station C travaillant en modulation de fréquence et qui sera décrite plus loin. La sortie de ce transformateur est reliée à une extrémité du coaxial à fuites par l'intermédiaire d'un isolateur I. Cet élément est consitué par une portion de câble coaxial bobiné sur un moyau magnétique, en ferrite par exemple. De cette manière, est créée une inductance de blocage des courants de gaine pour les fréquences correspondant aux ondes longues et moyennes, ce qui évite, pour ces ondes, la mise en court-circuit de la tresse extérieure du coaxial à fuites par les circuits contenus dans la station à modulation de fréquence C. Le câble coaxial est fermé à son autre extrémité sur une charge adaptée $R_3$, isolée de la masse. Au point de vue statique, la gaine L2 du câble à fuite et le câble L1 sont à la masse.

L'alimentation du transformateur $T_3$ peut se faire sous une impédance de 50 $\Omega$. L'impédance caractéristique du câble peut être de 75 $\Omega$. La charge $R_3$ est alors une résistance de 75 $\Omega$.

Le câble coaxial à fuites peut être formé, de manière connue, par une tresse bobinée hélicoïdalement en spires non jointives, autour d'un conducteur central. Cette structure de câble rayonnant à fuite n'est pas limitative. Un câble porteur soutient l'ensemble.

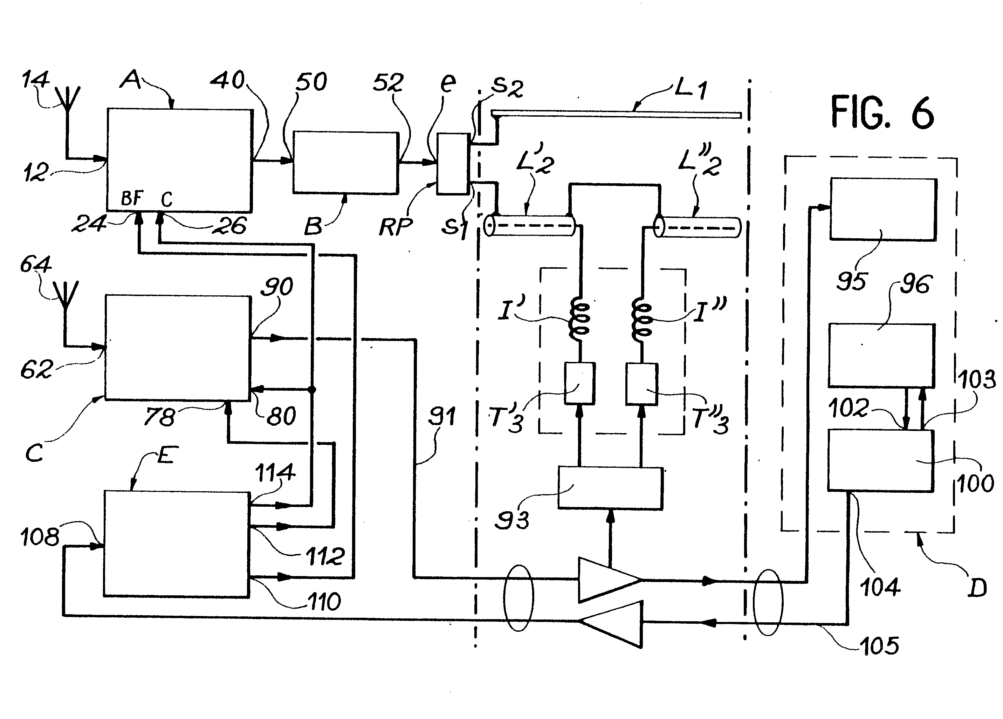

Sur la figure 3 le câble coaxial servant à constituer la ligne $L_2$ est d'une seule pièce mais ce câble peut être divisé en deux tronçons avec alimentation au centre (comme on le verra mieux sur la figure 6), ou en plusieurs paires de tronçons.

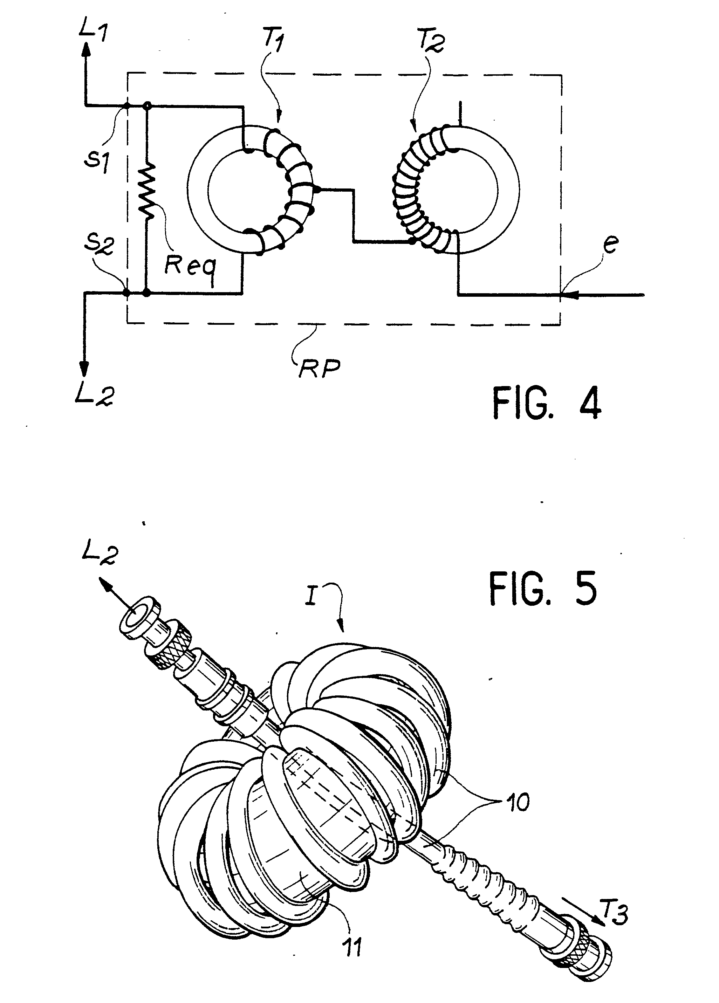

Un mode particulier de réalisation du répartiteur de puissance RP est représenté sur la figure 4. Un tel circuit comprend un premier transformateur $t_1$ à une entrée et deux sorties symétriques reliées aux sorties $s_1$, $s_2$ du répartiteur, une charge d'équilibrage Req reliant les deux sorties, un second transformateur $t_2$, servant de transformateur d'impédance, dont l'entrée est reliée à l'entrée e du répartiteur et la sortie à l'entrée du premier transformateur. De cette manière, l'interruption d'une des lignes ne perturbe en rien la transmission sur l'autre.

La figure 5 représente un isolateur obtenu en bobinant un câble coaxial 10 autour d'un noyau en ferrite 11.

L'équipement conforme à l'invention, qui permet d'alimenter le système rayonnant qui vient d'être décrit, est représenté schématiquement sur la figure 6. Un tel équipement est constitué par :

— une première station (A) de réception, de démodulation et de remodulation, cette station fonctionnant en modulation d'amplitude, et possédant une première entrée 12, reliée à une antenne 14, une deuxième entrée 24 recevant un signal en basse fréquence, une troisième entrée 26 recevant le signal de commutation et une sortie 40,

— un amplificateur de puissance B possédant une entrée 50 reliée à la sortie 40 de la première station A et une sortie 52 reliée à l'entrée e du répartiteur de puissance RP alimentant le système rayonnant,

— une seconde station C de·réception, de transposition et de retransposition de fréquence, cette

4

station fonctionnant en modulation de fréquence et possédant une première entrée 62 reliée à une antenne de réception 64, une deuxième entrée 78 recevant un signal à une fréquence intermédiaire, une troisième entrée 80 recevant un signal de commutation, et une sortie 90. Cette dernière est reliée, par une voie aller 91, à travers un séparateur 93 aux inductances de blocage l', l" reliées aux deux tronçons de câble coaxial L'$_2$ et L"$_2$,

— un poste de contrôle D comprenant un équipement de contrôle d'émission 95 relié à la sortie 90 de la station C, un pupitre de commande 96 pour la constitution de messages de service, un modulateur 100 travaillant en modulation de fréquence et possédant une entrée 102 reliée au pupitre 96 et recevant de celui-ci un signal de basse fréquence véhiculant un message de service et une sortie 104 délivrant un signal modulé à la fréquence intermédiaire utilisée dans la station C à modulation de fréquence, ce signal étant transmis à cette station C par une voie de retour 105,

— un équipement E de démodulation et de commande de commutation, cet équipement possédant une entrée 108 reliée à la sortie 104 du modulateur 100, une première sortie 110 délivrant des signaux démodulés de basse fréquence et reliée à l'entrée 24 de première station A travaillant en modulation d'amplitude, une seconde sortie 112 délivrant un signal transposé à la fréquence intermédiaire et reliée à l'entrée 78 de la seconde station C fonctionnant en modulation de fréquence, et une troisième sortie 114 délivrant un signal de commutation et reliée aux entrées de commande 26, 80 des première et seconde stations.

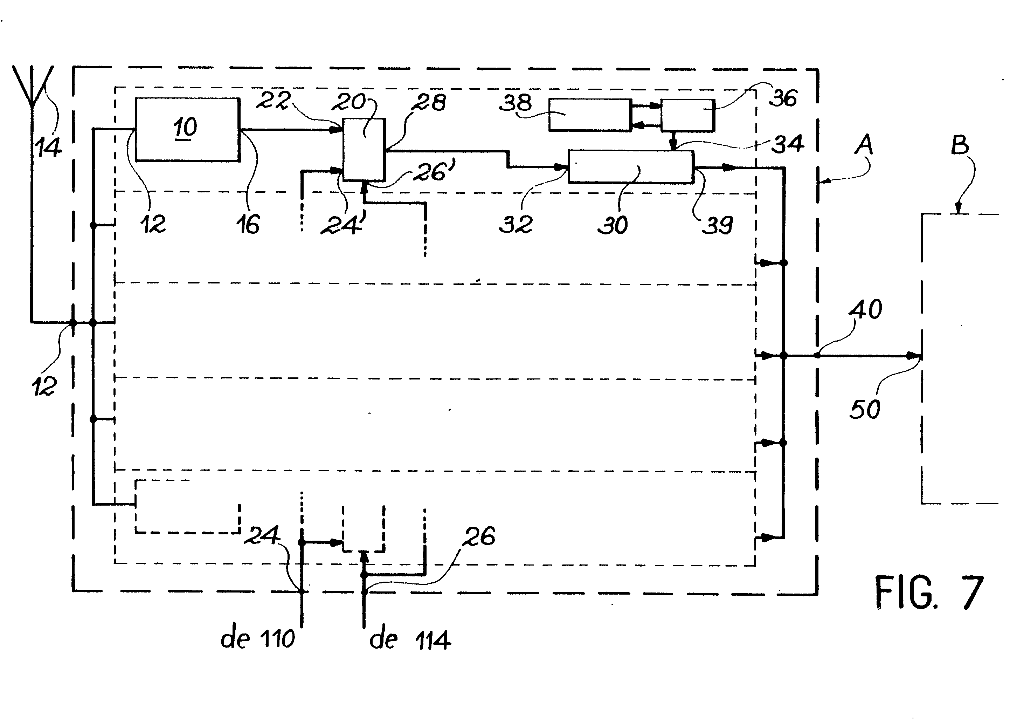

La structure de la première station A qui fonctionne en modulation d'amplitude, est représentée sur la figure 7. Cette station est composée d'une pluralité de voies de traitement (par exemple 5). Chaque voie comprend :

— un circuit de réception et de démodulation d'amplitude 10 réglé pour un programme radiodiffusé particulier en ondes kilométriques ou hectométriques ; ce circuit 10 possède une entrée 12 reliée à l'antenne de réception 14 et une sortie 16 délivrant un signal démodulé en basse fréquence,

— un commutateur basse fréquence 20, a une première entrée 22 reliée à la sortie 16 du circuit de réception et démodulation 10, et une seconde entrée 24' reliée à l'entrée commune 24 ; c'est cette seconde entrée qui reçoit le signal basse fréquence véhiculant le message de service pouvant se substituer au programme radiodiffusé ; ce commutateur 20 possédant encore une entrée de commande 26' reliée à l'entrée commune 26 qui reçoit le signal déterminant lequel des deux signaux de basse fréquence est adressé sur une sortie 28,

— un modulateur à modulation d'amplitude 30 possédant une première entrée 32 reliée à la sortie 28 du commutateur 20, une deuxième entrée 34 reliée à un oscillateur local formé d'un oscillateur commandé en tension 36 (VCO) et d'un oscillateur de référence 38, ce modulateur possédant encore une sortie 39 qui est reliée à la sortie générale 40 de la station.

On comprend que, selon le signal de commutation appliqué à l'entrée 26, le commutateur 20 adresse au modulateur 30, soit le signal basse fréquence correspondant au programme radiodiffusé reçu, soit le signal basse fréquence correspondant à un message de service qui vient alors se substituer au programme radiodiffusé.

Dans la station A à modulation d'amplitude, le modulateur 30 peut être d'un type particulier dans lequel on ajoute à l'onde modulée une porteuse en phase dont on règle le niveau à volonté. Ceci permet d'ajuster le taux de modulation et d'obtenir éventuellement une surmodulation.

L'amplificateur de puissance B disposé à la sortie de la station A à modulation d'amplitude, est du type à large bande. Grâce aux performances du système rayonnant de l'invention, cet amplificateur est unique pour toutes les voies et il fonctionne à un niveau de sortie plus faible que dans l'art antérieur.

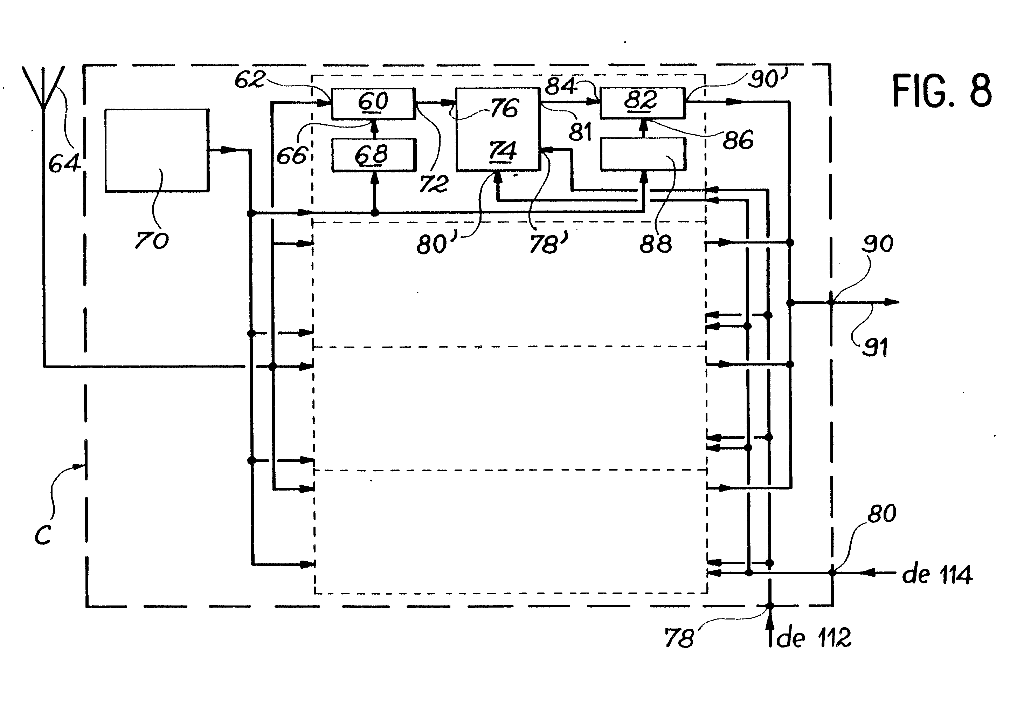

La deuxième station fonctionnant en modulation de fréquence, possèdent une structure qui est représentée sur la figure 8. Cette station est constituée d'une pluralité de voies de traitement (par exemple 4) comprenant chacune :

— une tête haute fréquence 60, possédant une première entrée 62 reliée à une antenne de réception 64, une deuxième entrée 66 reliée à un premier oscillateur local asservi, constitué par un oscillateur pilote 70, commun à toutes les voies, et un oscillateur local 68 ; cette tête haute fréquence possède une sortie 72 délivrant un signal à une fréquence intermédiaire égale à la différence entre la fréquence de la porteuse reçue sur la première entrée 62 et la fréquence du signal émis par l'oscillateur 68,

— un commutateur de signal 74 fonctionnant à la fréquence intermédiaire, possédant une première entrée 76 reliée à la sortie 72 de la tête haute fréquence 60 et une deuxième entrée 78' reliée à la première entrée générale 78 de la station, cette entrée 78' recevant un signal à la fréquence intermédiaire véhiculant un message de service, ce commutateur possédant encore une entrée de commande 80' reliée à la deuxième entrée générale 80 de la station, cette entrée 80' recevant un signal de commande de commutation ; le commutateur 74 possède enfin une sortie 81,

— un circuit de transposition de fréquence 82, possédant une première entrée 84 reliée à la sortie 81 du commutateur 74, une deuxième entrée 86 reliée à un deuxième oscillateur asservi constitué par l'oscillateur pilote 70 commun à toutes les voies et par un oscillateur local 88 ; le circuit 82 possède encore une sortie 90' reliée à la sortie générale 90 de la station. C'est cette sortie qui est reliée à la voie aller 91 alimentant les inductances de blocage connectées au câble coaxial à fuite.

Comme pour la première station, selon le signal de commutation appliqué à l'entrée 80, le commutateur 74 adresse au circuit de transposition de fréquence 82, soit le signal en fréquence intermédiaire correspondant à un programme radiodiffusé en modulation de fréquence, soit un signal en fréquence intermédiaire correspondant à un message de service.

Dans la station C, les commutateurs 74, fonctionnant en fréquence intermédiaire peuvent être du type électronique et utiliser des diodes PIN commandées par inversion de tension 12V. Les fréquences des trois voies en modulation de fréquence peuvent être réglées par exemple, respectivement, sur 93,5 MHz, 90,5 MHz et 98,6 MHz, ce qui, en France, correspond aux programmes de France Inter, France Culture et France Musique. La fréquence intermédiaire peut être située à 10,7 MHz.

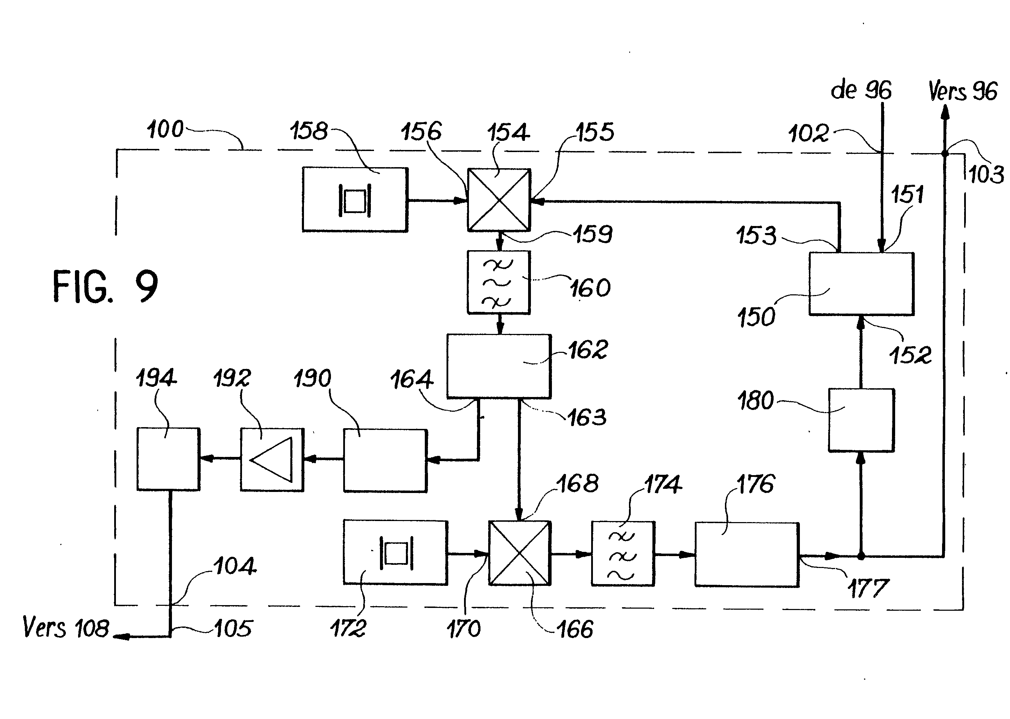

Un exemple de réalisation du modulateur 100 de la station de contrôle est représenté sur la figure 9. Ce circuit comprend un oscillateur à varicaps 150, à une entrée 151 reliée à l'entrée 102 du modulateur à une seconde entrée 152 et à une sortie 153 ; un mélangeur 154 à une première entrée 155 reliée à la sortie 153 de l'oscillateur 150 à une seconde entrée 156 reliée à un oscillateur à quartz 158 et à une sortie 159 ; un filtre passe bande 160 relié à la sortie 159 ; un coupleur 162 à une entrée reliée au filtre passe bande, et à deux sorties 163, 164 ; un mélangeur 166 possède une entrée 168 reliée à la sortie 163 du coupleur et une seconde entrée 170 reliée à un second oscillateur à quartz 172 ; un filtre passe-bas 174 relié au mélangeur 166 ; un démodulateur à comptage 176, dont la sortie 177 est reliée à une sortie générale de contrôle basse fréquence 103 connectée au circuit 96 (cf figure 6) ; un amplificateur 180, dont l'entrée est reliée à la sortie 177 du démodulateur et la sortie à l'entrée 152 de l'oscillateur 150. Le modulateur 100 comprend encore un commutateur 190 relié à la seconde sortie 164 du coupleur 162 ; un amplificateur 192 relié au commutateur 190 ; et enfin un atténuateur 194 relié à la sortie générale 104, laquelle délivre sur la voie de retour 105 un signal à la fréquence intermédiaire modulé par le signal basse fréquence appliqué à l'entrée générale 102. C'est ce signal qui peut se substituer au signal de même fréquence intermédiaire correspondant aux programmes radiodiffusés. L'oscillateur 158 fonctionne par exemple à 70 MHz. Après changement de fréquence dans le mélangeur 154 et filtrage dans le filtre 160, le signal utile se trouve centré à la fréquence intermédiaire de 10,7 MHz. Un asservissement en fréquence est obtenu par une commande automatique réalisée par la boucle comprenant le démodulateur à comptage 176.

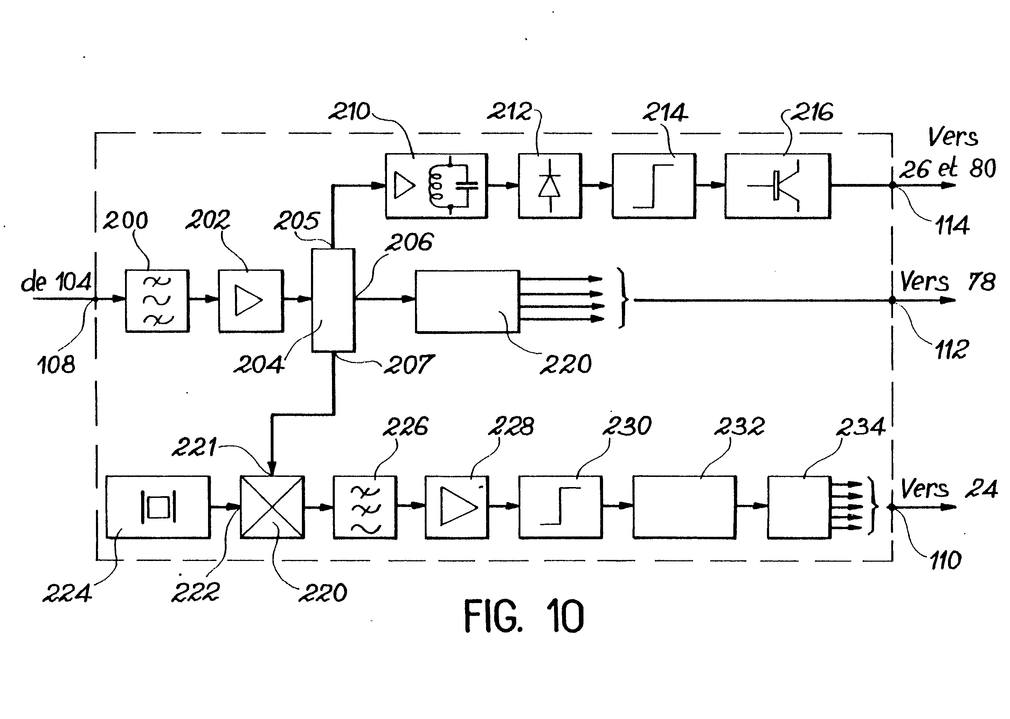

La figure 10 représente un mode particulier de réalisation de l'équipement E de démodulation et de commande de commutation. Tel que représenté, cet équipement comprend un filtre d'entrée passe-bande 200 relié à l'entrée générale 108 d'où il reçoit le signal modulé à la fréquence intermédiaire provenant de la sortie 104 du modulateur 100 ; un amplificateur 202 ; un coupleur 204 à trois sorties 205, 206 et 207 ; un amplificateur accordé 210 relié à la sortie 205 du coupleur ; un détecteur de crête 212, un comparateur 214 ; un interface 216 dont la sortie est reliée à la sortie générale 114, délivrant les signaux de commutation destinés aux entrées 26 et 80 des stations A et C.

L'équipement E comprend encore un distributeur de signaux à la fréquence intermédiaire 220 relié à la sortie 206 du coupleur 204, les sorties de ce distributeur étant reliées à la sortie générale 112 de l'équipement, laquelle est destinée à adresser à l'entrée 78 de la station C les signaux en fréquence intermédiaire représentant des messages de service devant se substituer aux programmes en modulation de fréquence.

L'équipement E comprend encore un mélangeur 220 dont une première entrée 221 est reliée à la troisième sortie 207 du coupleur 204 et une seconde entrée 222 est reliée à un oscillateur 224 ; un filtre passe-bas 226 ; un amplificateur 228 ; un comparateur 230 ; un démodulateur 232 ; et enfin un distributeur 234 dont les sorties sont reliées à la sortie générale 110 laquelle est destinée à fournir à l'entrée 24 de la station A, les signaux de basse fréquence représentant les messages de service devant se substituer aux programmes en modulation d'amplitude.

Le filtre d'entrée 200 peut avoir une largeur de 240 kHz à 3 dB. Il assure la sélection du canal. Le démodulateur 232 est du même type que le démodulateur 176.

Naturellement, dans tous les circuits décrits plus haut, on peut disposer des amplificateurs là où le besoin s'en fait sentir, par exemple avant et après les commutateurs 20 de la voie fonctionnant en modulation d'amplitude ou dans les voies aller 91 et retour 105.

On peut aussi utiliser des distributeurs placés à l'entrée des différentes voies des deux stations A et C, ou des unités de couplage à la sortie de ces voies. Ces différents moyens sont bien connus de l'homme de l'art et n'ont pas été illustrés par souci de simplification.

**Revendications**

1. Système rayonnant permettant la rediffusion dans un tunnel routier d'ondes correspondant à des programmes radiodiffusés en modulation d'amplitude et en modulation de fréquence et permettant la diffusion dans ce tunnel de messages de service, ce système étant caractérisé par le fait qu'il comprend, de chaque côté et le long du tunnel, un câble conducteur (7) suspendu à l'un des chemins métalliques (6) servant de support à divers câbles d'alimentation électrique, ce câble conducteur et ce chemin métallique constituant de chaque côté du tunnel, une ligne à fuite ($L_1$, $L_2$) fonctionnant en régime d'ondes progressives dans la gamme des ondes longues (kilométriques) et moyennes (hectométriques) correspondant à un régime de modulation d'amplitude, l'un au moins ($L_2$) de ces deux câbles conducteurs étant constitué par la gaine conductrice extérieure d'un câble coaxial à fuite, ce câble coaxial étant alimenté à une extrémité par un conducteur coaxial véhiculant une onde en modulation de fréquence, ce conducteur étant en partie bobiné sur un noyau magnétique et formant inductance de blocage (I) pour les ondes longues et moyennes, l'autre extrémité du câble coaxial étant connectée à une résistance adaptée ($R_3$), ce système comprenant encore un répartiteur de puissance (RP) à une entrée (e) recevant un signal correspondant à des programmes en ondes longues et moyennes et deux sorties identiques ($s_1$, $s_2$) délivrant des signaux de même amplitude et même phase, ces deux sorties ($s_1$, $s_2$) étant reliées respectivement à l'une des extrémités des câbles suspendus, chaque autre extrémité étant connectée à une charge adaptée ($R_1$, $R_2$).

2. Système rayonnant selon la revendication 1, caractérisé par le fait que le répartiteur de puissance (RP) comprend un premier transformateur ($t_1$) à une entrée et deux sorties symétriques ($s_1$, $s_2$), une charge d'équilibre (Req) reliant les deux sorties, un second transformateur ($t_2$) servant de transformateur d'impédance et ayant une entrée (e) recevant le signal correspondant aux ondes longues et moyennes et une sortie reliée à l'entrée du premier transformateur ($t_1$).

3. Equipement d'alimentation du système rayonnant selon la revendication 1, caractérisé en ce qu'il comprend :

A) une première station (A) fonctionnant en modulation d'amplitude, cette station étant composée d'une pluralité de voies de traitement comprenant chacune :

— un circuit de réception et de démodulation d'amplitude (10) pour un programme radiodiffusé en ondes kilométriques ou hectométriques, ce circuit (10) ayant une entrée (12) reliée à une antenne de réception (14) et une sortie (16) délivrant un signal démodulé en basse fréquence,

— un commutateur basse fréquence (20) a une première entrée (22) reliée à la sortie (16) du circuit de réception et démodulation (10), et une seconde entrée (23) reliée à une entrée commune (24) recevant un second signal basse fréquence véhiculant un message de service pouvant se substituer au programme radiodiffusé, ce commutateur (20) possédant une entrée de commande (25) reliée à une entrée de commande (26) recevant un signal de commande de commutation et une sortie (28),

— un modulateur à modulation d'amplitude (30) possédant une première entrée (32) reliée à la sortie (28) du commutateur (20), une deuxième entrée (34) reliée à un oscillateur local (36, 38) et une sortie (39) reliée à la sortie générale (40) de cette première station,

B) un amplificateur de puissance (B) possédant une entrée (50) reliée à là sortie (40) de la première station (A) et une sortie (52), cette sortie (52) étant reliée à l'entrée (e) du répartiteur de puissance (RP) alimentant le système rayonnant,

C) une deuxième station (C) fonctionnant en modulation de fréquence est constituée d'une pluralité de voies de traitement comprenant chacune :

— une tête haute fréquence (60) possédant une première entrée (62) reliée à une antenne de réception (64), une deuxième entrée (66) reliée à un premier oscillateur asservi (68, 70) et une sortie (72) délivrant un signal à une fréquence intermédiaire égale à la différence entre la fréquence de la porteuse reçue sur la première entrée (62) et la fréquence du premier oscillateur asservi (68, 70),

— un commutateur de signal à fréquence intermédiaire (74) possédant une première entrée (76) reliée à la sortie (72) de la tête haute fréquence (60) et une deuxième entrée reliée à une première entrée (78) de la station et recevant un signal à ladite fréquence intermédiaire et véhiculant un message de service pouvant se substituer au programme radiodiffusé en modulation de fréquence, ce commutateur possédant une entrée de commande (79) reliée à une deuxième entrée générale (80) de la station et recevant un signal de commande de commutation et possédant enfin une sortie (81),

— un circuit de transposition de fréquence (82) possédant une première entrée (84) reliée à la sortie (81) du commutateur (74), une deuxième entrée (86) reliée à un deuxième oscillateur asservi (88, 70) et une sortie (89) reliée à la sortie générale (90) de cette deuxième station, cette sortie étant reliée à l'inductance de blocage (I) servant à alimenter le câble coaxial à fuites du système rayonnant,

D) un poste de contrôle (D) comprenant :

— un modulateur (100) travaillant en modulation de fréquence et possédant une entrée (102) recevant un signal basse fréquence véhiculant un message de service et une sortie (104) délivrant un signal modulé à la fréquence intermédiaire utilisée dans des voies de traitement en modulation de fréquence,

E) un équipement de démodulation et de commande de commutation (E) à une entrée (108) reliée à la sortie (104) du modulateur (100) du poste de contrôle (D) et une première sortie (110) délivrant des signaux démodulés de basse fréquence, cette sortie étant reliée à l'entrée (24) de la première station (A), travaillant en modulation d'amplitude, une seconde sortie (112) délivrant un signal démodulé à la fréquence intermédiaire et étant reliée à l'entrée (78) de la seconde station (C) fonctionnant en modulation de fréquence et une troisième sortie (114) délivrant un signal de commutation et étant reliée aux entrées de commande (26, 80) des première et seconde stations.

## Claims

1. Radiating system which allows waves to be rebroadcast in a road tunnel, the waves corresponding to programmes broadcast with amplitude modulation and frequency modulation, and which allows service messages to be broadcast in this tunnel, this system being characterised in that it comprises, on each side and along the length of the tunnel, a conducting cable (7) suspended from one of the metallic rails (6) which serve to support various electric supply cables, this conducting cable and metallic rail forming, on each side of the tunnel, a return line ($L_1$, $L_2$) which functions in the range of travelling waves in the range of long waves (kilometrics) and medium waves (hectometrics) corresponding to an amplitude modulation range, at least one ($L_2$) of these two conducting cables being formed by the exterior conducting sheath of a coaxial return cable, this coaxial cable being supplied at one end by a coaxial conductor which carries a frequency modulated wave, this conductor being partially wound on a magnetic core and forming a blocking inductance (I) for long and medium waves, the other end of the coaxial cable being connected to an adapted resistance ($R_3$), this system further comprising a power distributor (RP) with one input (e) which receives a signal corresponding to programmes in long and medium waves and two identical outputs ($s_1$, $s_2$) which deliver signals of the same amplitude and phase, the two outputs ($s_1$, $s_2$) being connected to respective ends of the suspended cables, each other end being connected to an adapted load ($R_1$, $R_2$).

2. Radiating system according to claim 1, characterised in that the power distributor (RP) comprises a first transformer ($t_1$) with one input and two symmetrical outputs ($s_1$, $s_2$), an equalising load (Req) connecting the two outputs, a second transformer ($t_2$) which serves as an impedance transformer and has one input (e), which receives the signal corresponding to the long and medium waves, and one output connected to the input of the first transformer ($t_1$).

3. Equipment for supplying the radiating system according to claim 1, characterised in that it comprises :

A) a first unit (A) functioning with amplitude modulation, this unit being composed of a plurality of treatment means each comprising :
— a reception and amplitude demodulation circuit (10) for a programme broadcast in kilometric or hectometric waves, this circuit (10) having an input (12) connected to a reception antenna (14) and an output (16) which delivers a demodulated signal at a low frequency,
— a low frequency commutator (20) with a first input (22) connected to the output (16) of the reception and demodulation circuit (10) and a second input (23) connected to a common input (24) receiving a second low frequency signal carrying a service message which can be substituted for the broadcast programme, this commutator (20) having a control input (25) connected to a control input (26) receiving a commutation command signal and an output (28),
— an amplitude modulation modulator (30) having a first input (32) connected to the output (28) of the commutator (20), a second input (34) connected to a local oscillator (36, 38) and an output (39) connected to the general output (40) of this first unit,

B) a power amplifier (B) having an input (50) connected to the output (40) of the first unit (A) and an output (52), this output (52) being connected to the input (e) of the power distributor (RP) which supplies the radiating system,

C) a second unit (C) functioning with frequency modulation and formed of a plurality of treatment means, each comprising :
— a high frequency module (60) having a first input (62) connected to a reception antenna (64), a second input (66) connected to a first controlled oscillator (68, 70) and an output (72) delivering a signal at an intermediate frequency equal to the difference between the carrier frequency received at the first input (62) and the frequency of the first controlled oscillator (68, 70),
— an intermediate frequency signal commutator (74) having a first input (76) connected to the output (72) of the high frequency head (60) and a second input which is connected to a first input (78) of the unit and receives a signal at the said intermediate frequency and carries a service message which can be substituted for the programme broadcast with frequency modulation, this commutator having a control input (79), connected to a second general input (80) of the unit and receiving a commutation command signal, and finally having an output (81),
— a frequency transposition circuit (82) having a first input (84) connected to the output (81) of the commutator (74), a second input (86) connected to a second controlled oscillator (88, 70) and an output (89) connected to the general output (90) of this second unit, this output being connected to the blocking inductance (I) which serves to supply the coaxial return cable of the radiation system,

D) a control station (D) comprising :
— a modulator (100) operating with frequency modulation and having an input (102) which receives a low frequency signal carrying a service message and an output (104) which delivers a modulated signal at the intermediate frequency utilised in the treatment means as a frequency modulation,

E) a demodulation and commutation control apparatus (E) with one input (108) connected to the output (104) of the modulator (100) of the control station (D) and with a first output (110) delivering low frequency demodulated signals, this output being connected to the input (24) of the first unit (A), operating with amplitude modulation, a second output (112) delivering a demodulated signal at the intermediate frequency and being connected to the input (78) of the second unit (C) functioning with frequency modulation and a third output (114) delivering a commutation signal and being connected to the control inputs (26, 80) of the first and second units.

**Patentansprüche**

1. Ausstrahlungssystem zur Übertragung von Wellen, die in Amplituden- und Frequenzmodulation mit den ausgestrahlten Hörfunkprogrammen übereinstimmen, in Straßentunneln und zur Ausstrahlung von Dienstmeldungen in diesen Tunneln, dadurch gekennzeichnet, daß es ein Leitungskabel (7) an jeder Tunnelseite und entlang des Tunnels aufweist, das an einer der für verschiedene elektrische Versorgungsleitungen als Träger dienenden Metallführungen (6) aufgehängt ist, wobei dieses Leitungskabel und dieses Metallführung auf jeder Tunnelseite eine streuende Leitung ($L_1$, $L_2$) bilden, die amplitudenmodulierte Wanderwellen im Langwellenbereich (km) und Mittelwellenbereich (hm) übertragen, wobei mindestens eine ($L_2$) dieser zwei Leitungskabel von dem leitenden Außenmantel eines streuenden Koaxialkabels gebildet wird, das an einem Ende von einer eine frequenzmodulierte Welle transportierenden koaxialen Leitung gespeist wird, die teilweise um einen Magnetkern gewickelt ist und eine Sperrinduktanz (I) für Lang- und Mittelwellen bildet, und das am anderen Ende mit einem adaptierten Widerstand ($R_3$) verbunden ist, wobei dieses System weiter einen Leistungsverteiler (RP) aufweist, der einen Eingang (e) zum Empfang eines Langwellen- und Mittel wellenprogrammsignals besitzt, sowie zwei identische Ausgänge ($s_1$, $s_2$), die Signale mit gleicher Amplitude und gleicher Phase abgeben, wobei diese zwei Ausgänge ($s_1$, $s_2$) jeweils mit dem einen Ende der aufgehängten Kabel verbunden sind und die beiden anderen Enden jeweils an eine adaptierte Belastung ($R_1$, $R_2$) geschlossen sind.

2. Ausstrahlungssystem nach Anspruch 1, dadurch gekennzeichnet, daß der Leistungsverteiler (RP) einen ersten Transformator ($t_1$) mit einem Eingang und zwei symmetrischen Ausgängen ($s_1$, $s_2$) enthält, sowie eine Abgleichbelastung (Req), die die beiden Ausgänge verbindet, und einen zweiten Transformator ($t_2$), der als Widerstandswandler dient und einen Eingang (e) zum Empfang des Langwellen- und Mittelwellensignals und einen mit dem Eingang des ersten Transformators ($t_1$) verbundenen Ausgang hat.

3. Versorgungseinrichtung für das Ausstrahlungssystem nach Anspruch 1, dadurch gekennzeichnet, daß sie beinhaltet :

A) eine erste Station (A) zur Amplitudenmodulation, bestehend aus mehreren Umformungskanälen mit folgenden Bestandteilen :

— einem Empfangs- und Amplitudendemodulationskreis (10) für Rundfunkprogramme, die mit Langwelle oder Mittelwelle ausgestrahlt werden, wobei dieser Kreis (10) einen Eingang (12) besitzt, der mit einer Empfangsantenne (14) verbunden ist, und einen Ausgang (16), der ein demoduliertes Niederfrequenzsignal abgibt,

— einem Niederfrequenzumschalter (20) mit einem ersten Eingang (22), der mit dem Ausgang (16) des Empfangs- und Demodulationskreises (10) verbunden ist, und einem zweiten Eingang (23), der mit einem Sammeleingang (24) verbunden ist, welcher ein zweites Niederfrequenzsignal als Träger von Dienstdurchsagen, die die Rundfunkprogrammsendungen unterbrechen können, empfängt, wobei dieser Umschalter (20) einen Steuereingang (25) besitzt, der mit einem Steuereingang (26) zum Empfang eines Umschalt-Steuersignals verbunden ist, sowie einen Ausgang (28),

— einem Modulator zur Amplitudenmodulation (30) mit einem ersten Eingang (32), der mit dem Ausgang (28) des Umschalters (20) verbunden ist, einem zweiten Eingang (34), der mit einem Lokaloszillator (36, 38) verbunden ist, und einem Ausgang (39), der mit dem Hauptausgang (40) dieser ersten Station verbunden ist,

B) einen Leistungsverstärker (B) mit einem Eingang (50),·der mit dem Ausgang (40) der ersten Station (A) verbunden ist, und einem Ausgang (52), wobei dieser Ausgang (52) mit dem Eingang (e) des Leistungsverteilers (RP) verbunden ist, der zur Versorgung des Ausstrahlungssystems dient,

C) eine zweite Station (C) zur Frequenzmodulation, bestehend aus mehreren Umformungskanälen mit folgenden Bestandteilen :

— einem Hochfrequenzkopf (60) mit einem ersten Eingang (62), der mit einer Empfangsantenne (64) verbunden ist, einem zweiten Eingang (66), der mit einem ersten gesteuerten Oszillator (68, 70) verbunden ist, und einem Ausgang (72), der ein Signal mit einer Zwischenfrequenz abgibt, die gleich der Differenz zwischen der Frequenz der am ersten Eingang (62) empfangenen Trägerwelle und der Frequenz des ersten gesteuerten Oszillators (68, 70) ist,

— einem Zwischenfrequenzsignal-Umschalter (74) mit einem ersten Eingang (76), der mit dem Ausgang (72) des Hochfrequenzkopfs (60) verbunden ist, und einem zweiten Eingang, der mit einem ersten Eingang (78) der Station verbunden ist und ein Signal mit der genannten Zwischenfrequenz empfängt, die eine Dienstdurchsage transportiert, die das ausgestrahlte Rundfunkprogramm frequenzmoduliert unterbrechen kann, wobei dieser Umschalter einen Steuereingang (79) besitzt, der mit einem zweiten Haupteingang (80) der Station verbunden ist, ein Umschaltsteuersignal empfängt, sowie schließlich einen Ausgang (81) besitzt,

— einem Frequenzumsetzungskreis (82) mit einem ersten Eingang (84), der mit dem Ausgang (81) des Umschalters (74) verbunden ist, einen zweiten Eingang (86), der mit einem zweiten gesteuerten Oszillator (88, 70) verbunden ist, und einem Ausgang (89), der mit dem Hauptausgang (90) dieser zweiten Station verbunden ist, wobei dieser Ausgang mit der Sperrinduktanz (I) verbunden ist, die dazu dient, das streuende Koaxialkabel des Ausstrahlungssystems zu speisen,

D) eine Leitstation (D), bestehend aus :

— einem frequenzmodulierenden Modulator (100) mit einem Eingang (102), der ein Niederfrequenz-Trägersignal für eine Dienstdurchsage empfängt, und einem Ausgang (104), der ein Signal abgibt, das in die Zwischenfrequenz moduliert wurde, die in den Umformungskanälen der Frequenzmodulation benutzt wird,

E) eine Demodulations- und Umschaltsteuerungs-Einrichtung (E) mit einem Eingang (108), der mit dem Ausgang (104) des Modulators (100) der Leitstation (D) verbunden ist, und einem ersten Ausgang (110), der demodulierte Niederfrequenzsignale abgibt, wobei dieser Ausgang mit dem Eingang (24) der ersten Station (A) verbunden ist, die amplitudenmodulierend arbeitet, einem zweiten Ausgang (112), der ein in die Zwischenfrequenz demoduliertes Signal abgibt und mit dem Eingang (78) der zweiten, frequenzmodulierenden, Station (C) verbunden ist, und einem dritten Ausgang (114), der ein Umschaltsignal abgibt und mit den Steuereingängen (26, 80) der ersten und zweiten Station verbunden ist.

FIG. 1

FIG. 2

FIG. 3

FIG. 4

FIG. 5

FIG. 6

0 153 239

FIG. 7

0 153 239

FIG. 8

0 153 239

FIG. 9

de 104 → [200] → [202] → [205] [207]

210 → 212 → 214 → 216 → Vers 26 et 80 → 114

206 → 220 → Vers 78 → 112

221 → [224] → [222] 220 → [226] → [228] → [230] → [232] → [234] → Vers 24 → 110

108

204

FIG. 10

0 153 239